# EUROPÄISCHE PATENTSCHRIFT

(11) **EP 3 970 273 B1**
(45) Veröffentlichungstag und Bekanntmachung des Hinweises auf die Patenterteilung: **27.11.2024**
(21) Anmeldenummer: 20721419.8
(22) Anmeldetag: 24.04.2020
(51) Int. Cl.: H03K 17/955, H03K 17/975, H03K 17/98

(54) **SENSORMODUL, -SYSTEM UND VERFAHREN ZUM BETREIBEN DES SENSORMODULS UND -SYSTEMS**
SENSOR MODULE, SENSOR SYSTEM AND METHOD FOR OPERATING THE SENSOR MODULE AND SENSOR SYSTEM
MODULE DE CAPTEURS, SYSTÈME DE CAPTEURS ET PROCÉDÉ POUR FAIRE FONCTIONNER LE MODULE ET LE SYSTÈME DE CAPTEURS

(30) Priorität: 16.05.2019 DE 102019112962
(43) Veröffentlichungstag der Anmeldung: 23.03.2022
(73) Patentinhaber: Karlsruher Institut für Technologie, 76131 Karlsruhe (DE)
(72) Erfinder: ALAGI, Hosam, 76137 Karlsruhe (DE)
(86) Internationale Anmeldenummer: PCT/EP2020/025186
(87) Internationale Veröffentlichungsnummer: WO 2020/228981

(56) Entgegenhaltungen:
- DE-A1- 102010 049 484
- DE-B3- 102016 109 800
- US-A1- 2009 146 827
- US-A1- 2013 076 375

## Beschreibung

Die Erfindung betrifft ein kapazitives Sensormodul und Sensorsystem sowie ein Verfahren zum Betreiben des Sensormoduls und des Sensorsystems. Das Sensormodul dient zum Erfassen der Annäherung eines Objekts an das Sensormodul und zum kapazitiven Erfassen von taktilen Ereignissen zwischen einem Objekt und dem Sensormodul, wobei dies hierin synonym mit dem Erfassen von Taktilität zu verstehen ist. Das Sensorsystem basierend auf dem Sensormodul dient zum kapazitiven Erfassen der Annäherung eines Objekts an das Sensormodul und zum kapazitiven Erfassen von taktilen Ereignissen zwischen einem Objekt und dem Sensormodul, umfassend eine Vielzahl von Sensormodulen. Das Verfahren dient zum kapazitiven Erfassen der Annäherung eines Objekts und zum kapazitiven Erfassen von taktilen Ereignissen mittels des Sensormoduls oder Sensorsystems. Das Sensormodul, das Sensorsystem bzw. das Verfahren dieser betrifft ferner eine sichere Mensch-Maschine-Interaktion (Interaktion, Kooperation, Kollaboration) und kann die funktionale Sicherheit von kapazitiven Messsystemen zur Erfassung der Annäherung und der Berührung von Menschen und Gegenständen in der unmittelbaren Umgebung steigern. Die Erfindung betrifft ferner einen Schichtaufbau mit elektrischer Schaltung zur funktionalen Absicherung von einem kapazitiven Erfassungssystem.

### Stand der Technik

Bei einem kapazitiven Messsystem zur Erfassung der Annäherung von Objekten z.B. Menschen und des mechanischen Kontakts oder zwischen Sensor und Objekt mangelt es in vielen Fällen an der Funktionalen Sicherheit. So können beispielsweise die Messelektroden ausfallen oder beschädigt werden, in der Art, dass ein interpretierbares Signal vorhanden ist, aber dennoch nicht die Sicherheitssituation wiedergibt. D.h. es muss kein toter technischer Ausfall des Messsystems vorliegen, jedoch sind die empfangenen Signale nicht plausibel bzw. nachvollziehbar und bedürfen einer redundanten Verifikation.

Eine beliebte Lösung ist eine redundante Ausführung des Messsystems auf verschieden Ebenen (d.h. auf analoger und/oder digitaler Ebene).

Eine weitere, in **[1]** vorgestellte Lösung für reine Näherungsmessung umfasst die Überwachung der Funktionalität, indem das zu auswertende Messsignal moduliert wird und anschließend diese Modellierung geprüft wird. Hierfür wird eine zusätzliche (Prüf-) Elektrode mit Prüfimpulse benötigt.

In **[2]** wird eine Lösung vorgestellt, die ebenfalls eine zusätzliche (Test-) Elektrode benötigt. Hier wird die Test Elektrode über einen Schalter mit einer bestimmen Frequenz an die Masse angeschlossen und die Wirkung auf die weiteren Elektroden durch die vorgeschnellten Messschaltung geprüft.

In beiden oben genannten Referenzen wird ausschließlich eine Näherungsmessung realisiert, es werden hierfür zusätzliche Elektroden zum Prüfen benötigt und das Messsignal wird moduliert um die Funktionalität zu prüfen, indem die Modulierung ausgewertet wird.

Ein weiteres bekanntes Sensormodul ist aus der US 2009/146827 A1 bekannt und offenbart eine beidseitig-kapazitive Annäherungskonfiguration und eine beidseitig-kapazitive Taktilitätskonfiguration.

### Aufgabe

Dieser Erfindung liegt die objektive technische Aufgabe zugrunde ein Sensormodul, ein darauf basierendes Sensorsystem und Verfahren zum Betreiben des Sensormoduls und -systems bereitzustellen, welches bei gleichem Aufbau des Sensormoduls eine zusätzliche funktionale Sicherheit aufweist.

### Lösung

Diese zuvor genannte objektiv technische Aufgabe wird mit den hierin offenbarten Verfahren gemäß dem Gegenstand des ersten unabhängigen Anspruchs 1 gelöst. Hierauf bezogene Neben- bzw. Unteransprüche geben vorteilhafte Ausgestaltungen bzw. Ausführungsformen wieder. Vorteilhafte Weiterbildungen, welche einzeln oder in beliebiger Kombination realisierbar sind, sind in den abhängigen Ansprüchen dargestellt. Die funktionale Sicherheit eines erfindungsgemäßen Sensormoduls mit gleichem Aufbau, d.h. die Anzahl eines solchen Sensorelemente bleibt unverändert, wird dadurch bereitgestellt, dass es mit einem solchen erfindungsgemäßen Aufbau möglich ist, die Sensorelemente des Sensormoduls auf totale oder teilweise Beschädigung bzw. Kurzschlüsse zwischen den Sensorelementen oder Trennung von der Messeinheit als auch die Messeinheit, d.h. die Generierung eines Erregersignals, auf Funktionstüchtigkeit hin zu prüfen.

Im Folgenden werden die Begriffe "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben den durch diese Begriffe eingeführten Merkmalen, keine weiteren Merkmale vorhanden sind, oder auf Situationen, in welchen ein oder mehrere weitere Merkmale vorhanden sind. Beispielsweise kann sich der Ausdruck "A weist B auf", "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder sogar weitere Elemente.

Weiterhin wird darauf hingewiesen, dass die Begriffe "mindestens ein" und "ein oder mehrere" sowie grammatikalische Abwandlungen dieser Begriffe, wenn diese in Zusammenhang mit einem oder mehreren Elementen oder Merkmalen verwendet werden und ausdrücken sollen, dass das Element oder Merkmal einfach oder mehrfach vorgesehen sein kann, in der Regel lediglich einmalig verwendet werden, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "vorzugsweise", "insbesondere", "beispielsweise (bspw.)" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung, wie der Fachmann erkennen wird, auch unter Verwendung anderer Ausgestaltungen durchgeführt werden. In ähnlicher Weise werden Merkmale, welche durch "in einer Ausführungsform" oder durch "in einer weiteren Ausführungsform" eingeleitet werden, als optionale Merkmale verstanden, ohne dass hierdurch alternative Ausgestaltungen oder der Schutzumfang der unabhängigen Ansprüche eingeschränkt werden soll. Weiterhin sollen durch diese einleitenden Ausdrücke sämtliche Möglichkeiten, hierdurch eingeleitete Merkmale mit anderen Merkmalen zu kombinieren, seien es optionale oder nicht-optionale Merkmale, unangetastet bleiben.

### Allgemeine Beschreibung

Unter den folgenden Begriffen bzw. Oberbegriffen ist in dieser Offenbarung zu verstehen:
Ein "Sensorelement" bzw. "Sensorelemente" sind elektrisch zumindest teilweise leitfähige und nicht leitfähige Elemente, Komponenten oder Bauteile, die jeweils derart eingerichtet sind, dass ein elektrisches Potential daran anlegbar ist. Dabei wird ein elektrisches Feld gebildet, indem an ein zumindest teilweise elektrisch leitfähiges Sensorelement ein elektrisches Potential angelegt wird. Das elektrische Feld bildet sich dabei zwischen mehreren zumindest teilweise elektrisch leitfähigen Sensorelementen mit unterschiedlichen Potentialen bzw. zwischen zumindest teilweise elektrisch leitfähigen Sensorelementen und einem oder mehreren Objekten in der Umgebung des jeweiligen Sensorelements. Solche Sensorelemente sind auch in der Fachliteratur bspw. als Elektroden bekannt. Ein Sensormodul besteht aus mehreren zumindest teilweise elektrisch leitfähigen und nicht leitfähigen Sensorelementen. Zur Durchführung einer Messung wird das Sensormodul an eine Messeinheit elektrisch leitfähig angeschlossen bzw. daran elektrisch leitfähig gekoppelt ist. Diese Messeinheit umfasst mindestens drei Kapazitätsmesseinrichtungen, die zur Erfassung der Annäherung der Taktilität und zu Prüfung der Funktionalität des Sensorsystems eingerichtet sind. Dementsprechend umfasst ein Sensorsystem mindestens ein Sensormodul und eine Messeinheit.

Baut sich das elektrische Feld zwischen einem Sensorelement und einem Objekt auf bzw. wird zwischen diesen gebildet, so wird dies als selbst-kapazitiver Modus bezeichnet. Baut sich das elektrische Feld zwischen zwei Sensorelementen auf oder wird zwischen diesen gebildet, so wird dies als beidseitig-kapazitiver Modus bezeichnet. Im beidseitig-kapazitiven Modus unterscheidet man zwischen Sender, an dem ein elektrisches Potenzial anliegt, und Empfänger, der im einfachsten Fall über einen Messwiderstand an die Masse elektrisch leitfähig angeschlossen oder daran elektrisch leitfähig gekoppelt ist.

In einer "Annäherungskonfiguration" ist die Annäherung des Objekts in zwei Modi erfassbar. Im selbst-kapazitiven Modus baut bzw. bildet sich ein elektrisches Feld zwischen einem zumindest teilweise elektrisch leitfähigen Sensorelement und zumindest einem Objekt in der Umgebung des Sensorelements auf. Durch die Annäherung des Objektes zum Sensorelement hin wird das elektrische Feld verändert. Diese Veränderung wird vom Sensorsystem erfasst und als Annäherungssignal weitergegeben. Im beidseitig-kapazitiven Modus baut bzw. bildet sich ein elektrisches Feld zwischen einem Sender- und einem Empfängersensorelement auf. Die Veränderung des elektrischen Feldes durch ein sich annäherndes Objekt kann sowohl empfängerseitig als auch senderseitig erfasst und als sogenanntes "Annäherungssignal" weitergegeben werden. In beiden Modi kann diese Kopplung des elektrischen Feldes mit einem Abschirmelement gezielt beeinflusst werden, z.B. um die Koppelung zu weiteren Sensorelementen oder zur Messeinheit zu verringern bzw. zu unterbinden. Hierfür wird das Potential des zumindest teilweise leitfähigen Sensorelements mit einer Operationsverstärkerschaltung, ein sogenannter "Spannungsfolger", am Abschirmelement gespiegelt. Diese Methode wird als "aktive Abschirmung" bezeichnet und unterscheidet sich von einer passiven Abschirmung dadurch, dass eine passive Abschirmung durch Anschließen des Abschirmelements an die Masse realisiert wird.

In einer "Taktilitätskonfiguration" baut bzw. bildet sich ein elektrisches Feld zwischen zwei zumindest teilweise elektrisch leitfähigen Sensorelementen auf, wobei zwischen diesen beiden Sensorelementen zumindest ein elektrisch isolierendes und komprimierbare Schicht angeordnet ist. Hierfür wird mindestens an ein zumindest teilweise elektrisch leitfähiges Sensorelement ein elektrisches Potential angelegt. Dies entspricht einem beidseitig-kapazitiven Modus. Hierbei wird die Veränderung des Abstandes zwischen den beiden zumindest teilweise elektrisch leitfähigen Sensorelementen, d.h. bei der Komprimierung des komprimierbaren Sensorelements, empfängerseitig vom Sensorsystem erfasst und als sogenanntes "Taktilitätssignal" weitergegeben.

In einer "Prüfkonfiguration" wird das zweite äußere Sensorelement, das in der Taktilitätskonfiguration als Empfänger dient, an eine Kapazitätsmesseinrichtung elektrisch leitfähig angeschlossen bzw. damit elektrisch leitfähig gekoppelt. Diese Kapazitätsmesseinrichtung umfasst elektronische Schaltungen und Komponente zur Auswertung der Funktionalität des Sensorsystems.

Eine "Sensorelementstapelanordnung" beschreibt, wie die oben beschriebenen Sensorelemente zueinander angeordnet sind. Dabei sind zumindest ein erstes äußeres zumindest teilweise elektrisch leitfähiges Sensorelement, zumindest ein zumindest teilweise elektrisch leitfähiges Zentralsensorelement, eine elektrisch isolierende und komprimierbare Schicht und zumindest ein zweites zumindest teilweise elektrisch leitfähiges Sensorelement übereinander angeordnet, wobei das zumindest eine erste äußere zumindest teilweise elektrisch leitfähige Sensorelement und das zumindest eine zumindest teilweise elektrisch leitfähige Zentralsensorelement elektrisch isoliert übereinander angeordnet sind. D.h. die zumindest teilweise elektrisch leitfähigen Sensorelemente können optional derart eingerichtet sein, dass sich an einer deren Oberflächen, die an ein benachbartes Sensorelement angrenzen, elektrisch isolierend gebildet sein.

Hierin wird eine Lösung zur Prüfung der Funktionalität eines kapazitiven Messsystems bereitgestellt. Die Prüfung dieser Funktionalität prüft dabei, ob das Erregersignal oder mindestens eine Messelektrode (hierin auch synonym als Sensorelement bezeichnet) ausgefallen oder beschädigt sind. Ein solcher Ausfall des Sensorelements kann bspw. dadurch entstehen, dass mindestens eine Elektrode bzw. Sensorelement in Teilen, d.h. zumindest eine vollständige Bruchstelle derart aufweist, dass das Sensorelement zweigeteilt ist, oder dessen Verbindung zur Messeinheit getrennt ist oder wenn ein Kurzschluss zwischen mindestens zwei Elektroden bzw. Sensorelement entsteht.

Für die Lösung sind keine zusätzlichen Elektroden bzw. Sensorelemente erforderlich. Dazu wird eine der zumindest drei Elektroden bzw. Sensorelemente, d.h. insbesondere die die Taktilität erfasst, wird mit einer passiven Prüfschaltung zeitgleich bzw. synchron überwacht.

In einer ersten Ausführungsform umfasst ein Sensormodul zum kapazitiven Erfassen der Annäherung eines Objekts an das Sensormodul und zum kapazitiven Erfassen von taktilen Ereignissen zwischen einem Objekt und dem Sensormodul: mindestens drei Sensorelemente, wobei die Sensorelemente zumindest teilweise elektrisch leitfähig und derart übereinander und voneinander beabstandet angeordnet sind, dass eine Sensorelementstapelanordnung gebildet wird und jeweils an die Sensorelemente ein elektrisches Potential anlegbar ist und die Sensorelemente voneinander elektrisch isoliert sind, und wobei die Sensorelementstapelanordnung zumindest ein erstes und ein zweites äußeres Sensorelement und zumindest ein, zwischen den beiden äußeren Sensorelementen angeordnetes, Zentralsensorelement aufweist; mindestens eine komprimierbare Schicht, die zwischen zwei der Sensorelemente angeordnet ist; dadurch gekennzeichnet, dass das Sensormodul derart eingerichtet ist, dass es mit drei verschiedenen Mess-Konfigurationen und zumindest einer beidseitig-kapazitiven Prüf-Konfiguration betreibbar ist, wobei die Mess-Konfigurationen umfassen: eine selbst-kapazitive Annäherungskonfiguration, eine beidseitig-kapazitive Annäherungskonfiguration, und eine beidseitig-kapazitive Taktilitätskonfiguration, und wobei die Annäherungskonfiguration Annäherungs- und die beidseitig-kapazitive Taktilitätskonfiguration gleichzeitig betreibbar ist.

Durch die Anordnung sind Annäherungs- und Taktilitätsereignisse synchron erfassbar und die Funktionalität der Anordnung prüfbar. Ein solches System hat den Vorteil, dass es durch diese Anordnung mit geringem Aufwand realisierbar ist.

In einer weiteren Ausführungsform umfasst das Sensormodul eine Messeinheit, welche derart eingerichtet ist, die Sensorelemente in den Mess- und Prüf-Konfigurationen zu betreiben.

Damit können die Annäherungs- und Taktilitätsereignisse erst erfasst und die Funktionalität geprüft.

In einer weiteren Ausführungsform umfasst die Messeinheit zwei Kapazitätsmesseinrichtung: eine erste Kapazitätsmesseinrichtung, derart eingerichtet, dass eine Annäherungsmessung durchführbar und ein Abschirmpotential erzeugbar ist, und eine zweite Kapazitätsmesseinrichtung, derart eingerichtet, dass eine taktile Messung und eine Prüf-Messung durchführbar ist.

Durch diesen Aufbau der Messeinheit ist eine synchrone Mess- und Prüfkonfiguration betreibbar, womit eine zeitlich lückenlose Erfassung der Annäherungs- und Taktilitätsereignisse und Prüfung der Funktionalität realisierbar ist.

In einer weiteren Ausführungsform weist die Messeinheit eine Erregersignalerzeugungseinheit, eine erste Kapazitätsmesseinrichtung und eine zweite Kapazitätsmesseinrichtung auf; wobei: in der selbst-kapazitiven Annäherungskonfiguration zumindest eines der äußeren Sensorelemente sowohl mit der Erregersignalerzeugungseinheit als auch mit der ersten Kapazitätsmesseinrichtung verbunden ist und wobei das Zentralsensorelement mit dem Abschirmpotential betrieben wird; in der beidseitig-kapazitiven Annäherungskonfiguration das zumindest erste äußere Sensorelement mit der ersten Kapazitätsmesseinrichtung verbunden ist und wobei das Zentralsensorelement mit dem Abschirmpotential betrieben wird; und in der beidseitig-kapazitiven Taktilitätskonfiguration das zumindest eine zweite äußere Sensorelement mit der zweiten Kapazitätsmesseinrichtung verbunden ist.

Durch diese Zusammensetzung eines Sensormoduls und einer Messeinheit wird in der selbst-kapazitiven und beidseitig-kapazitiven Annäherungskonfiguration zumindest eines der äußeren Sensorelemente durch Zentralsensorelement abgeschirmt und dadurch Einflüsse von der hinteren Seite des äußeren Sensorelements verhindert. Weiterhin wird synchron über das zweite äußere Sensorelement die Taktilität im beidseitig-kapazitiven Modus ohne Unterbrechung oder Umschaltung jeglicher Art erfasst.

In einer weiteren Ausführungsform ist die Messeinheit derart eingerichtet, dass in der selbst-kapazitiven Annäherungskonfiguration eine Kapazität oder eine Änderung der Kapazität zwischen zumindest einem der äußeren Sensorelemente und einem Objekt messbar ist, wobei die Messeinheit derart eingerichtet ist, dass in der beidseitig-kapazitiven Annäherungskonfiguration eine Kapazität oder eine Änderung der Kapazität zwischen zumindest einem der äußeren Sensorelemente des Sensormoduls und einem der äußeren Sensorelemente des Sensormoduls messbar ist, und wobei die Messeinheit derart eingerichtet ist, dass in der beidseitig-kapazitiven Taktilitätskonfiguration eine Kapazität oder eine Änderung der Kapazität zwischen dem zumindest einen Zentralsensorelement und einem der äußeren Sensorelemente messbar ist.

Die Annäherungs- und Taktilitätsereignisse verursachen eine Kapazitätsänderung. Durch diese Zusammensetzung eines Sensormoduls und einer Messeinheit ist die Kapazitätsänderung in selbst-kapazitiven und beidseitig-kapazitiven Annäherungskonfiguration synchron und in der beidseitig-kapazitive Taktilitätskonfiguration messbar, womit eine zeitlich lückenlose Erfassung der Annäherungs- und Taktilitätsereignisse realisierbar ist.

In einer weiteren Ausführungsform weist die Messeinheit eine Verstärkerschaltung zur Erfassung der Annäherung in der selbst-kapazitive und beidseitig-kapazitive Annäherungskonfiguration auf, und/oder wobei die Messeinheit eine Verstärkerschaltung zur Erfassung der Taktilität aufweist, und/oder wobei die Messeinheit eine Verstärkerschaltung für die Prüfmessung aufweist, und/oder wobei die Messeinheit einen Spannungsfolger aufweist, wobei der Spannungsfolger in der selbst-kapazitiven Annäherungskonfiguration und/oder in der beidseitig-kapazitiven Annäherungskonfiguration mit dem zumindest einen Zentralsensorelement elektrisch leitfähig gekoppelt ist.

Durch den Spannungsfolger ist die Abschirmung realisierbar. Dadurch ergibt sich auch das nötige elektrische Potenzial für die beidseitig-kapazitive Taktilitätskonfiguration. Es sind drei Verstärkerschaltungen für die jeweiligen Mess- und Prüfkonfigurationen. Diese werden Parabel betrieben, wodurch eine synchrone Aufbereitung des Mess- und Prüfsignale realisierbar ist.

In einer weiteren Ausführungsform umfasst ein Sensorsystem zum kapazitiven Erfassen der Annäherung eines Objekts an das Sensormodul und zum kapazitiven Erfassen von taktilen Ereignissen zwischen einem Objekt und dem Sensormodul eine Vielzahl von Sensormodulen gemäß einer der vorhergehenden Ausführungsformen.

Dadurch ist parallele Betreiben von Vielzahl eines Sensormoduls realisierbar, womit die Erfassung von Annährungs- und Taktilitätsereignissen im größeren Raum / für größere Flasche abdeckbar ist.

In einer weiteren Ausführungsform sind die Sensormodule zu einem Array angeordnet sind, und/oder wobei die Messeinheiten der Sensormodule derart eingerichtet sind, dass jeweils zwei aneinandergrenzende Cluster von ersten äußeren Sensorelementen der Vielzahl von Sensormodulen zusammenschaltbar ist.

Durch die Zusammenschaltung mehrerer erste äußere Sensorelemente ergibt sich ein neues erstes äußeres Sensorelement mit größeren Fläche und durch höhere Messreichweite in der Annäherungskonfiguration.

In einer weiteren Ausführungsform umfasst ein Verfahren zum kapazitiven Erfassen der Annäherung eines Objekts und zum kapazitiven Erfassen von taktilen Ereignissen die Schritte: Bereitstellen eines oder mehrerer Sensormodule gemäß einer der vorhergehenden Ausführungsform von Sensormodulen oder Bereitstellen eines Sensorsystems gemäß einer der vorhergehenden Ausführungsform von Sensorsystemen; Betreiben der Sensorelemente in der selbst-kapazitiven Annäherungskonfiguration oder der beidseitig-kapazitiven Annäherungskonfiguration und Erfassen von Annäherungs-Messdaten; und/oder Betreiben der Sensorelemente in der beidseitig-kapazitiven Taktilitätskonfiguration und Erfassen von Taktilitäts-Messdaten, dadurch gekennzeichnet, dass die Sensorelemente in der beidseitig-kapazitiven Prüf-Konfiguration betrieben werden.

In einer weiteren Ausführungsform basierend auf der vorhergehenden Ausführungsform werden die Sensorelemente abwechselnd in der selbst-kapazitiven Annäherungskonfiguration betrieben.

Dadurch werden die Vorteile des selbst-kapazitiven und beidseitig-kapazitiven Modus kombiniert, was einen breiteren Anwendungsbereich ermöglicht.

Die Erfindung umfasst auch die Verwendung eines Sensormoduls oder eines Sensorsystems gemäß einem der o.g. Ausführungsformen, d.h. als taktiler Näherungssensor in funktionalen Oberflächen, als taktiler Näherungssensor in einem Hubwagen und/oder zur Ausbildung einer Sensorhaut in der Robotik.

Dadurch sind die genannten Beispiele in der Lage, die Annäherung von Objekten bspw. Gegenstände oder Menschen und den Kontakt mit dem Sensormodul zu erfassen. Eine Lokalisierung des Objekts ist dann durch weitere Schritte machbar. Für geführte Systeme können dementsprechend Hinweise und oder Warnsignale erzeugt werden und für autonome Systeme können Aktionen abgeleiert werden, wie Ausweißen oder annähern. Weiterhin dienen diese Oberflächen als Interaktionsschnittstellen.

### Kurzbeschreibung der Figuren

Weitere Einzelheiten und Merkmale der vorliegenden Erfindung ergeben sich aus der nachfolgenden Beschreibung eines bevorzugten Ausführungsbeispiels, insbesondere in Verbindung mit den abhängigen Ansprüchen. Hierbei können die jeweiligen Merkmale für sich alleine oder zu mehreren in Kombination miteinander verwirklicht sein. Die Erfindung ist nicht auf die Ausführungsbeispiele bzw. formen beschränkt.

Die Ausführungsbeispiele bzw. -formen sind schematisch in den nachfolgenden Figuren dargestellt. Hierbei bezeichnen gleiche Bezugsziffern in den Figuren gleiche oder funktionsgleiche Elemente bzw. hinsichtlich ihrer Funktionen einander entsprechende Elemente.

Zur Veranschaulichung und ohne einschränkende Wirkung ergeben sich weitere Merkmale und Vorteile der Erfindung aus der Beschreibung der beigefügten Zeichnungen. Darin zeigen:
- **Fig. 1**: eine schematische Darstellung einer ersten Ausführungsform eines erfindungsgemäßen Sensormoduls;
- **Fig. 2**: eine schematische Darstellung einer weiteren Ausführungsform eines erfindungsgemäßen Sensormodules;
- **Fig. 3**: eine schematische Darstellung einer weiteren Ausführungsform eines erfindungsgemäßen Sensormoduls in gleichzeitigen selbst-kapazitiven Annäherungskonfiguration und beidseitig-kapazitiven Taktilitätskonfiguration;
- **Fig. 4**: eine schematische Darstellung einer weiteren Ausführungsform eines erfindungsgemäßen Sensormoduls in gleichzeitigen selbst-kapazitiven Annäherungskonfiguration und beidseitig-kapazitiven Taktilitätskonfiguration;
- **Fig. 5**: eine schematische Darstellung einer weiteren Ausführungsform einer erfindungsgemäßen Messeinheit in gleichzeitigen selbst-kapazitiven Annäherungskonfiguration und beidseitig-kapazitiven Taktilitätskonfiguration; und
- **Fig. 6**: eine schematische Darstellung einer weiteren Ausführungsform einer erfindungsgemäßen Messeinheit in gleichzeitigen beidseitig -kapazitiven Annäherungskonfiguration und beidseitig-kapazitiven Taktilitätskonfiguration.

### Detaillierte Beschreibung

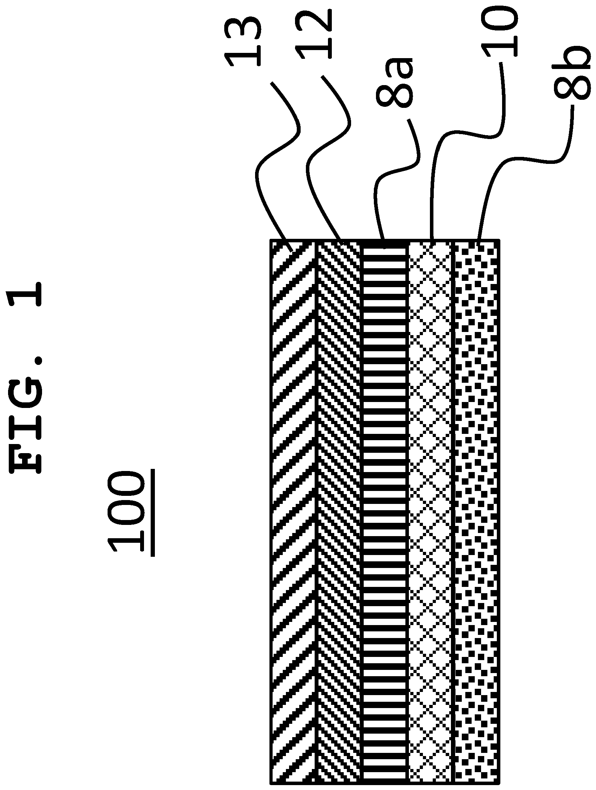

**Fig. 1** zeigt eine schematische Darstellung einer ersten Ausführungsform eines erfindungsgemäßen Sensormoduls **100** umfassend fünf Sensorelemente davon drei zumindest teilweise elektrisch leitfähige Sensorelemente **13, 8a** und **8b** und einem elektrisch isolierenden Element bzw. einer elektrisch isolierenden Schicht **12** und einem elektrisch isolierenden und komprimierbaren Sensorelement **10.** In einer optionalen Ausführungsform sind die Sensorelemente **13** und **8a** in einer Annäherungskonfiguration angeordnet, wobei das zumindest eine äußere Sensorelement **13** mit einem Erregersignal beaufschlagt wird und das dabei anliegende Potential wird an dem Zentralsensorelement **8a,** das als aktives Abschirmelement fungiert, gespiegelt. Zugleich wird das zumindest eine zweite äußere Sensorelement **8b** an mindestens eine Kapazitätsmesseinrichtung angeschlossen und die kapazitive Kopplung wird zwischen dem zumindest einen ersten äußeren Sensorelement **8a** und dem zumindest einen Zentralsensorelement **8b** in der Taktilitäts- und Prüfkonfiguration ausgewertet.

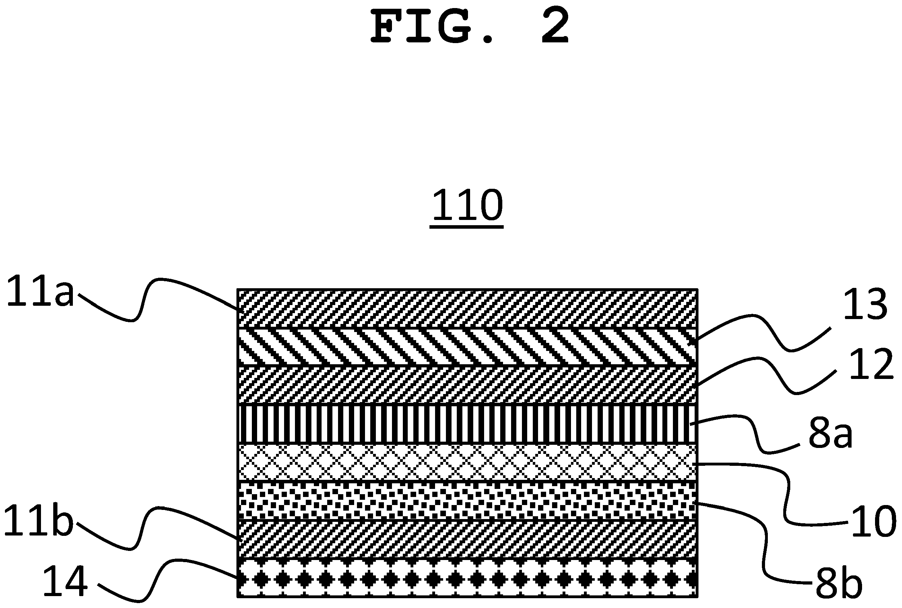

In **Figur 2** zeigt eine schematische Darstellung einer weiteren Ausführungsform eines erfindungsgemäßen Sensormodules. **Fig. 2** stellt dabei schematisch eine erweiterte Realisierung des oben beschriebenen Sensormoduls **100** dar. Hier kann das Sensormodul **100** noch ein zusätzliches elektrisch isolierendes Element bzw. eine zusätzliche elektrisch isolierende Schicht **11,** das/die an die äußere Seite eines äußeren Sensorelemente **13** und/oder **8b** angeordnet ist, umfassen. Die isolierenden Sensorelemente **11a** und/oder **11b** können, je nach Anwendungsfall, als Schutzelement gegen Betriebsbedingungen oder als Montageschichten am Sensorelement **100** angebracht werden. Beispielsweise kann vor dem Anbringen des Sensorelements **100** an zumindest teilweise elektrisch leitfähige Oberflächen, wie z.B. einen Roboterarm oder einem Fahrzeug, ein äußeres Sensorelement mit einer selbstklebenden elektrischen Isolationsschicht versehen werden. Des Weiteren kann das Sensormodul **100** ein zusätzliches zumindest teilweise elektrisch leitfähiges Sensorelement **14,** welches geerdet ist, umfassen. Ein solches Sensorelement kann den Kennlinienverlauf einer Messung beeinflussen, insbesondere verbessern, d.h. aufgrund eines geringeren Signal-zu-Rausch-Verhältnis das Erfassen geringerer Signalstärken zu ermöglichen. Sensorelemente **11a, 11b** und **14** sind optional, jedoch für die prinzipielle, d.h. erfindungsgemäße Funktionalität des Sensormoduls **100** nicht wesentlich.

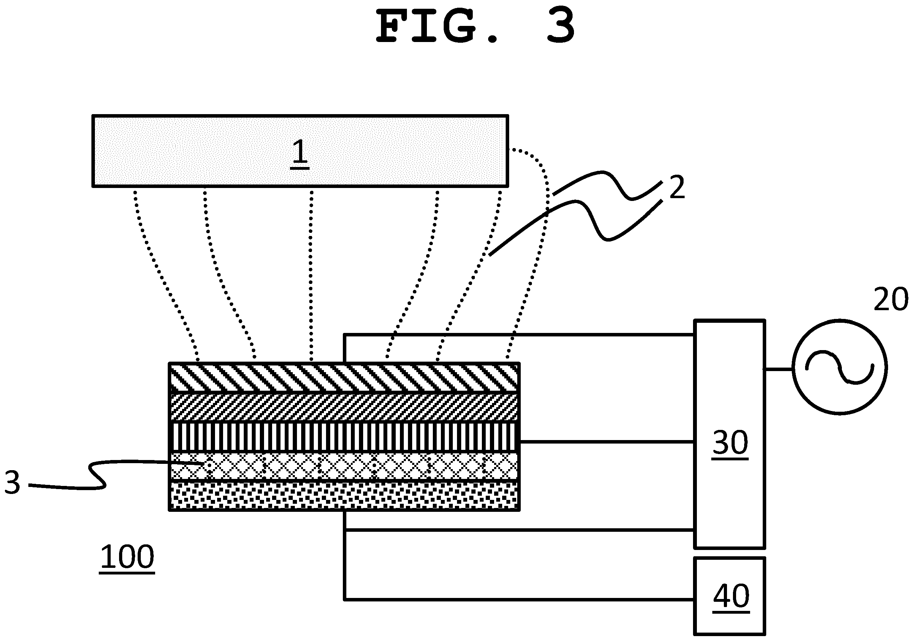

**Fig. 3** zeigt eine schematische Darstellung einer weiteren Ausführungsform eines erfindungsgemäßen Sensormoduls mit selbst-kapazitiver Annäherungskonfiguration und beidseitig-kapazitiver Taktilitätskonfiguration, wobei die beiden Konfigurationen, d.h. Annäherungs- und Taktilitätskonfiguration, synchron bzw. gleichzeitig betrieben werden. Die Annäherungskonfiguration kann in zwei Modi realisiert werden. **Fig. 3** stellt schematisch eine Annäherungskonfiguration im selbst-kapazitiven Modus dar. Hierzu wird mittels einer Erregersignalerzeugungseinheit bzw. Wechselspannungsquelle **20** eine Wechselspannung auf einem der äußeren Sensorelemente bspw. Sensorelement **13** beaufschlagt. Durch die Wechselspannung wird ein elektrisches Feld um das äußere Sensorelement **13** herum aufgebaut bzw. gebildet. Objekte **1** oder weitere Sensormodule bzw. Sensorelemente in der Umgebung beeinflussen das elektrische Feld **2.** Der dabei anliegende elektrische Strom wird in einer Kapazitätsmesseinrichtung **30** gemessen bzw. erfasst. Das Zentralsensorelement **8a** dient als aktive Abschirmung, um Einflüsse von der Rückseite des Sensormoduls **100** zu verhindern. Da die Sensorelemente **13** und **8a** dasselbe Potential aufweisen, bildet sich zwischen diesen kein elektrisches Feld.

In der Taktilitätskonfiguration erfolgt die taktile Messung, indem man die Kapazität zwischen einem inneren Sensorelement bzw. dem Zentralsensorelement **8a** und dem zumindest einem zweiten äußeren Sensorelement **8b** misst. Die obengenannten Sensorelemente sind über ein elektrisch nicht-leitfähiges bzw. elektrisch isolierendes, komprimierbares Sensorelement **10** voneinander getrennt. Eine Kraft, die auf das Sensormodul ausgeübt wird, bewirkt, dass zumindest ein Teil dieser Kraft eine Komprimierung des elektrisch isolierenden Sensorelements **10** bewirkt. Diese Komprimierung führt zu einer Abstandänderung zwischen dem Zentralsensorelement **8a** und dem zumindest einen zweiten äußeren Sensorelement **8b** und somit zu einer messbaren Kapazitätsänderung.

In der Prüfkonfiguration wird das, an dem Sensorelement **8b** kapazitiv gekoppelte, Potential von einer Kapazitätsmesseinrichtung **40** überwacht und ausgewertet. Eine Störung dieser Kopplung durch z.B. eine Beschädigung zumindest eines Sensorelements oder die Entstehung von Kurzschlüssen zwischen den Sensorelementen, wird von der Kapazitätsmesseinrichtung **40** erfasst.

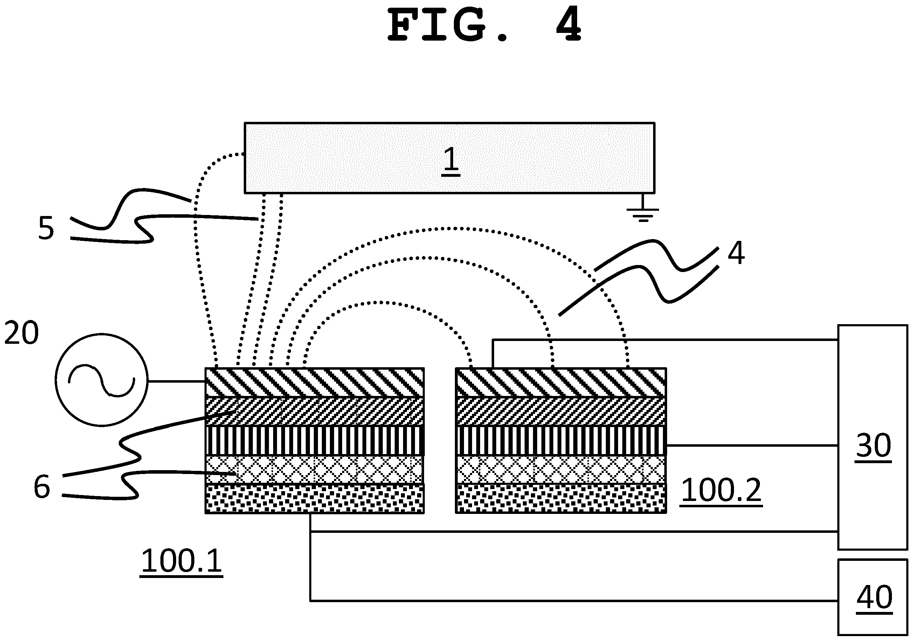

**Fig. 4** zeigt eine schematische Darstellung einer weiteren Ausführungsform eines erfindungsgemäßen Sensormoduls in gleichzeitigen selbst-kapazitiven Annäherungskonfiguration und beidseitig-kapazitiven Taktilitätskonfiguration. **Fig. 4** stellt schematisch die Näherungs- und Taktilitätskonfiguration im beidseitig-kapazitiven Messmodus dar. Es werden zwei identische Ausführungen des Sensormoduls **100** als Sender-Sensormodul **100.1** und als Empfänger-Sensormodul **100.2** betrieben. An das äußere Sensorelement **13** vom Sender-Sensormodul **100.1** wird mittels einer Erregersignalerzeugungseinheit bzw. Wechselspannungsquelle **20** eine Wechselspannung angelegt. Das äußere Sensorelement **13** des Sender-Sensormoduls **100.2** wird an einer Kapazitätsmesseinrichtung **30** elektrisch leitfähig angeschlossen bzw. elektrisch leitfähig daran gekoppelt, welche die Kapazität zwischen dem Sensorelement **13** des Sender-Sensormoduls **100.1** und dem Sensorelement **13** vom Sender-Sensormodul **100.2** erfasst. In der Taktilitätskonfiguration erfolgt die taktile Messung, indem man die Kapazität zwischen dem zumindest einen Zentralsensorelement **8a** des Sensormoduls **100.1** und dem zumindest einen zweiten äußeren Sensorelement **8b** des Sensormoduls **100.1** erfasst. In der Prüfkonfiguration wird das, an dem Sensorelement **8b** kapazitiv gekoppelte, Potential von einer Kapazitätsmesseinrichtung **40** überwacht und ausgewertet. Eine Störung dieser Kopplung durch z.B. eine Beschädigung zumindest einen Sensorelements des Sensormoduls **100.1** oder die Entstehung von Kurzschlüssen zwischen den Sensorelementen im Sensormodul **100.1,** wird von der Kapazitätsmesseinrichtung **40** erfasst.

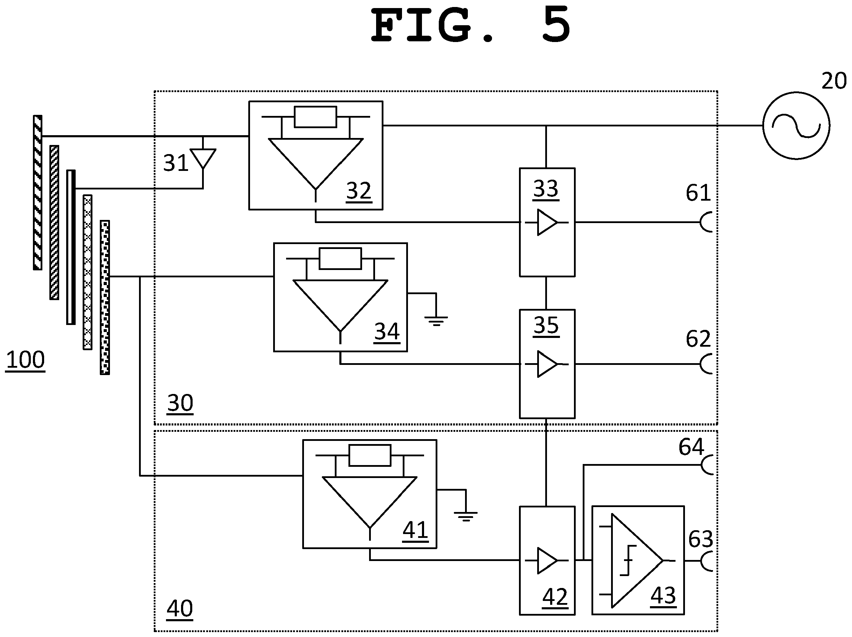

**Fig. 5** zeigt eine schematische Darstellung einer weiteren Ausführungsform einer erfindungsgemäßen Messeinheit selbst-kapazitiven Annäherungskonfiguration und beidseitig-kapazitiven Taktilitätskonfiguration, wobei die beiden Konfigurationen, d.h. Annäherungs- und Taktilitätskonfiguration, synchron bzw. gleichzeitig betrieben werden. **Fig. 5** dabei stellt schematisch die Komponenten der Kapazitätsmesseinrichtung **30** und **40** dar. In der Kapazitätsmesseinrichtung wird die aktive Abschirmung betrieben, indem das Potential des zumindest einen Zentralsensorelement **8a** mit Hilfe eines Spannungsfolgers **31,** welcher einen Verstärkungsfaktor von **1** aufweist, an das Potential des zumindest einen ersten äußeren Sensorelements **13** angeglichen. Eine Verstärkerschaltung **32** und ein Demodulator **33** erfassen die Kapazität zwischen dem äußeren Sensorelement **13** und dem Objekt **1** in der selbst-kapazitiven Annäherungskonfiguration und geben diese als Annäherungssignal **61** weiter. Zeitgleich bzw. synchron erfassen eine Verstärkerschaltung **34** und ein Demodulator **35** die Kapazität zwischen dem zumindest einen Zentralsensorelement **8a** und dem zumindest einen zweiten äußeren Sensorelement **8b** in der beidseitigen-kapazitiven Taktilitätskonfiguration und geben diese als Taktilitätssignal **62** weiter. In der Prüfkonfiguration erfassen eine Verstärkerschaltung **41** und ein Demodulator **42** die kapazitive Kopplung zwischen dem zumindest einen Zentralsensorelement **8a** und dem zumindest einen zweiten äußeren Sensorelement **8b** und leiten ein korrespondiertes Signal unteranderem an einem Komparator/Schallsignal **43** weiter. Der Komparator/Schallsignal **43** wertet des Signal aus und gibt ein Prüf-/Schaltsignal **64/63,** wenn vordefinierte bzw. zuvor bestimmte Schwellwerte überschritten/unterschritten werden, welche auf einen Funktionsfehler hindeuten. Hierbei sind der Demodulator **42** und der Komparator/Schallsignal **43** eine optionale Ausführungsform der Signalauswertung in der Prüfkonfiguration.

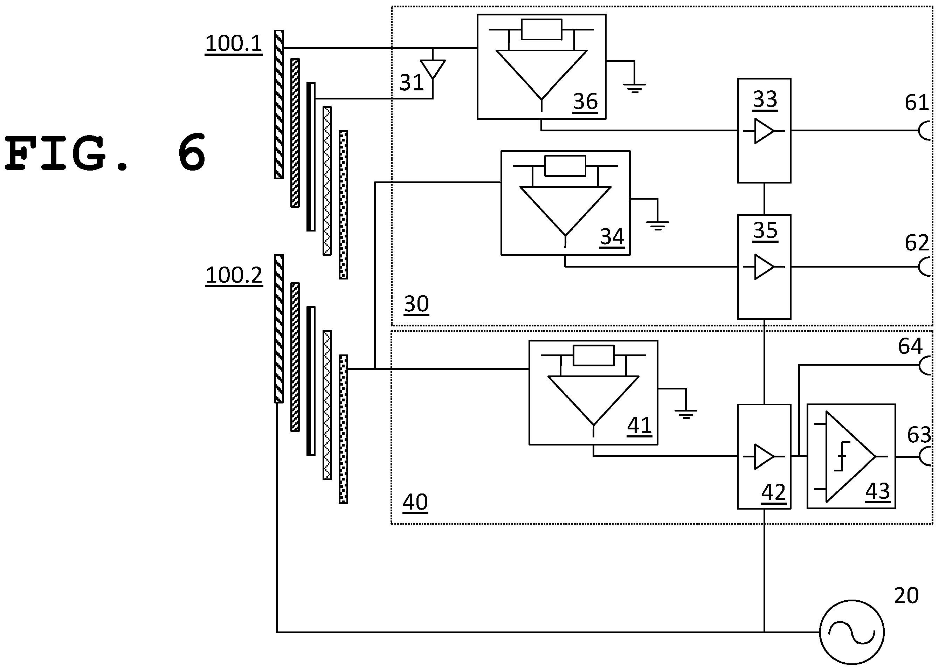

**Fig. 6** zeigt eine schematische Darstellung einer weiteren Ausführungsform einer erfindungsgemäßen Messeinheit mit beidseitig-kapazitiver Annäherungskonfiguration und beidseitig-kapazitiver Taktilitätskonfiguration, wobei die beiden Konfigurationen, d.h. Annäherungs- und Taktilitätskonfiguration, synchron bzw. gleichzeitig betrieben werden. Eine Verstärkerschaltung **36** und ein Demodulator **33** erfassen die Kapazität zwischen dem äußeren Sensorelement **13** des Sensormoduls **100.2** und dem Sensorelement des Sensormoduls **100.1** in der beidseitig-kapazitiven Annäherungskonfiguration und geben diese als Annäherungssignal **61** weiter. Zeitgleich erfassen eine Verstärkerschaltung **34** und ein Demodulator **35** die Kapazität zwischen dem zumindest eine Zentralsensorelement **8a** und dem zumindest einen zweiten äußeren Sensorelement **8b** des Sensormoduls **100.2** in der beidseitigen-kapazitiven Taktilitätskonfiguration und geben diese als Taktilitätssignal **62** weiter. In der Prüfkonfiguration erfassen eine Verstärkerschaltung **41** und ein Demodulator **42** die kapazitive Kopplung zwischen dem zumindest einen ersten äußeren Sensorelement **13** und dem zumindest einen zweiten äußeren Sensorelement **8b** des Sensormoduls **100.2** und leiten ein korrespondiertes Signal unteranderem an einen Komparator/Schallsignal **43** weiter. Der Komparator/Schallsignal **43** wertet das Signal aus und gibt ein Prüf-/Schaltsignal **64/63,** wenn vordefinierte bzw. zuvor bestimmter Schwellwerte überschritten/unterschritten wird, welcher auf einen Funktionsfehler hindeutet. Hierbei sind der Demodulator **42** und der Komparator/Schallsignal **43** eine optionale Ausführungsform der Signalauswertung in der Prüfkonfiguration.

### Literaturliste

**[1]** EP 0 341 576 B1
**[2]** DE 10 2016 109 800 B3

### Bezugszeichenliste

- **1........**: Ein Objekt/Gegenstand
- **2........**: Elektrische Feldlinien in der selbst-kapazitiven Annäherungskonfiguration
- **3........**: Elektrische Feldlinien in der beidseitig-kapazitiven Taktilitätskonfiguration
- **4........**: Elektrische Feldlinien in der beidseitig-kapazitiven Annäherungskonfiguration zwischen den Sensormodulen
- **5........**: Elektrische Feldlinien in der beidseitig-kapazitiven Annäherungskonfiguration zwischen dem Objekt 1 und dem Sensormodul 100.1
- **6........**: Elektrische Feldlinien in der beidseitig-kapazitiven Taktilitätskonfiguration in dem Sensormodul 100.1
- **100......**: Ein Sensormodul bestehend aus drei elektrisch leitenden Sensorelementen und einem elektrisch isolierenden Element oder einer elektrisch isolierenden Schicht und einem elektrisch isolierenden und komprimierbaren Sensorelement
- **100.1....**: eine identische Ausführung von 100 als Sender-Sensormodul im beidseitig-kapazitiven Messmodus
- **100.2....**: eine identische Ausführung von 100 als Empfänger-Sensormodul im beidseitig-kapazitiven Messmodus
- **110......**: Ein erweitertes Sensormodul bestehend aus vier elektrisch leitfähigen Sensorelementen und zwei elektrisch isolierenden Sensorelement und einem elektrisch isolierenden und komprimierbaren Element oder eine elektrisch isolierende Schicht
- **11a......**: ein äußeres zumindest teilweise elektrisch isolierendes Sensorelement
- **11b......**: ein inneres elektrisch isolierendes Sensorelement
- **13.......**: ein erstes äußeres zumindest teilweise elektrisch leitfähiges Sensorelement für Annäherungskonfiguration
- **12.......**: ein elektrisch isolierendes Element oder eine elektrisch isolierende Schicht
- **10.......**: ein elektrisch isolierendes und komprimierbares Sensorelement
- **8a.......**: ein zumindest teilweise elektrisch leitfähiges Zentralsensorelement zum Abschirmen
- **8b.......**: ein zweites äußeres zumindest teilweise elektrisch leitfähiges Sensorelement für die Taktilitätskonfiguration und Prüfkonfiguration
- **14.......**: ein zusätzliches zweites äußeres zumindest teilweise elektrisch leitendes Sensorelement zum Abschirmen
- **20.......**: ein Signalerzeuger
- **30.......**: eine Kapazitätsmesseinrichtung für die Annäherungs- und die Taktilitätskonfiguration
- **31.......**: ein Verstärker
- **32.......**: eine Verstärkerschaltung für die selbst-kapazitive Annäherungskonfiguration
- **33.......**: ein Demodulator für die Annäherungskonfiguration
- 34**.......**: eine Verstärkerschaltung für die Taktilitätskonfiguration
- **35.......**: ein Demodulator für die Taktilitätskonfiguration
- **36.......**: eine Verstärkerschaltung für die beidseitig-kapazitive Annäherungskonfiguration
- **40.......**: eine Kapazitätsmesseinrichtung für die Prüfkonfiguration
- **41.......**: eine Verstärkerschaltung für die Prüfkonfiguration
- **42.......**: ein Demodulator für die Prüfkonfiguration
- **43.......**: ein Komparator/Schaltsignalgeber für die Prüfkonfiguration
- **61.......**: Annäherungssignal
- **62.......**: Taktilitätssignal
- **63.......**: Prüfsignal
- **64.......**: Schaltsignal

## Patentansprüche

1. Sensormodul **(100)** zum kapazitiven Erfassen der Annäherung eines Objekts **(1)** an das Sensormodul **(100)** und zum kapazitiven Erfassen von taktilen Ereignissen zwischen einem Objekt **(1)** und dem Sensormodul **(100),** umfassend:
**a.** mindestens drei Sensorelemente **(13, 8a, 8b),**
**i.** wobei die Sensorelemente **(13, 8a, 8b)** zumindest teilweise elektrisch leitfähig und derart übereinander und voneinander beabstandet angeordnet sind, dass eine Sensorelementstapelanordnung gebildet wird und jeweils an die Sensorelemente **(13, 8a, 8b)** ein elektrisches Potential anlegbar ist und die Sensorelemente voneinander elektrisch isoliert sind, und
**ii.** wobei die Sensorelementstapelanordnung zumindest ein erstes und ein zweites äußeres Sensorelement **(13, 8b)** und zumindest ein, zwischen den beiden äußeren Sensorelementen angeordnetes, Zentralsensorelement **(8a)** aufweist;
**b.** mindestens eine komprimierbare Schicht **(10),** die zwischen zwei der Sensorelemente **(8a, 8b)** angeordnet ist;
wobei
**c.** das Sensormodul **(100)** derart eingerichtet ist, dass es mit drei verschiedenen Mess-Konfigurationen und zumindest einer beidseitig-kapazitiven Prüf-Konfiguration betreibbar ist,
**i.** wobei die Mess-Konfigurationen umfassen:
1. eine selbst-kapazitive Annäherungskonfiguration,
2. eine beidseitig-kapazitive Annäherungskonfiguration,
und
3. eine beidseitig-kapazitive Taktilitätskonfiguration;
und
**ii.** wobei die Annäherungs- und die beidseitig-kapazitive Taktilitätskonfiguration gleichzeitig betreibbar ist.

2. Sensormodul **(100)** gemäß Anspruch **1,** umfassend eine Messeinheit, welche derart eingerichtet ist, die Sensorelemente **(13, 8a, 8b)** in den Mess- und Prüf-Konfigurationen zu betreiben.

3. Sensormodul gemäß Anspruch **2,**
**a.** wobei die Messeinheit zwei Kapazitätsmesseinrichtung **(40)** umfasst:
**i.** eine erste Kapazitätsmesseinrichtung, derart eingerichtet, dass eine Annäherungsmessung durchführbar und ein Abschirmpotential erzeugbar ist, und
**ii.** eine zweite Kapazitätsmesseinrichtung, derart eingerichtet, dass eine taktile Messung und eine Prüf-Messung durchführbar ist.

4. Sensormodul **(100)** gemäß einem der vorhergehenden Ansprüche **2** bis **3,** wobei die Messeinheit eine Erregersignalerzeugungseinheit **(20),** eine erste Kapazitätsmesseinrichtung und eine zweite Kapazitätsmesseinrichtung **(40)** aufweist, wobei:
**a.** in der selbst-kapazitiven Annäherungskonfiguration zumindest eines der äußeren Sensorelemente **(13, 8b)** sowohl mit der Erregersignalerzeugungseinheit als auch mit der ersten Kapazitätsmesseinrichtung verbunden ist und wobei das Zentralsensorelement **(8a)** mit dem Abschirmpotential betrieben wird;
**b.** in der beidseitig-kapazitiven Annäherungskonfiguration das zumindest eine erste äußere Sensorelement **(13)** mit der ersten Kapazitätsmesseinrichtung verbunden ist und wobei das Zentralsensorelement **(8a)** mit dem Abschirmpotential betrieben wird; und
**c.** in der beidseitig-kapazitiven Taktilitätskonfiguration das zumindest eine erste äußere Sensorelement **(13)** mit der Erregersignalerzeugungseinheit verbunden ist und das Zentralsensorelement **(8a)** mit dem Abschirmpotential betrieben wird und das zumindest eine zweite äußere Sensorelement **(8b)** mit der zweiten Kapazitätsmesseinrichtung verbunden ist.

5. Sensormodul **(100)** gemäß einem der vorhergehenden Ansprüche **2** bis **4,**
**a.** wobei die Messeinheit derart eingerichtet ist, dass in der selbst-kapazitiven Annäherungskonfiguration eine Kapazität oder eine Änderung der Kapazität zwischen zumindest einem der äußeren Sensorelemente **(13, 8b)** und einem Objekt **(1)** messbar ist,
**b.** wobei die Messeinheit derart eingerichtet ist, dass in der beidseitig-kapazitiven Annäherungskonfiguration eine Kapazität oder eine Änderung der Kapazität zwischen zumindest einem der äußeren Sensorelemente **(13, 8b)** des Sensormoduls **(100.1)** und einer der äußeren Sensorelemente **(13, 8b)** des Sensormoduls **(100.2)** messbar ist,
und
**c.** wobei die Messeinheit derart eingerichtet ist, dass in der beidseitig-kapazitiven Taktilitätskonfiguration eine Kapazität oder eine Änderung der Kapazität zwischen dem zumindest einen Zentralsensorelement **(8a)** und einem der äußeren Sensorelemente **(13, 8b)** messbar ist.

6. Sensormodul **(100)** gemäß einem der vorhergehenden Ansprüche **2** bis **5,**
**a.** wobei die Messeinheit eine Verstärkerschaltung **(32)** zur Erfassung der Annäherung in der selbst-kapazitive Annäherungskonfiguration und eine Verstärkerschaltung **(36)** zur Erfassung der Annäherung in der beidseitig-kapazitive Annäherungskonfiguration aufweist,
und/oder
**b.** wobei die Messeinheit eine Verstärkerschaltung **(34)** zur Erfassung der Taktilität aufweist,
und/oder
**c.** wobei die Messeinheit eine Verstärkerschaltung **(41)** für die Prüfmessung aufweist,
und/oder
**d.** wobei die Messeinheit einen Spannungsfolger **(31)** aufweist,
**i.** wobei der Spannungsfolger **(31)** in der selbst-kapazitiven Annäherungskonfiguration und/oder in der beidseitig-kapazitiven Annäherungskonfiguration mit dem zumindest einen Zentralsensorelement **(8a)** elektrisch leitfähig gekoppelt ist.

7. Sensorsystem zum kapazitiven Erfassen der Annäherung eines Objekts an das Sensormodul **(100)** und zum kapazitiven Erfassen von taktilen Ereignissen zwischen einem Objekt **(1)** und dem Sensormodul **(100),** umfassend eine Vielzahl von Sensormodulen **(100)** gemäß einem der vorangehenden Ansprüche **1** bis **6.**

8. Sensorsystem gemäß Anspruch **7,**
**a.** wobei die Sensormodule **(100)** zu einem Array angeordnet sind,
und/oder
**b.** wobei die Messeinheiten der Sensormodule **(100)** derart eingerichtet sind, dass jeweils zwei aneinandergrenzende Cluster von ersten äußeren Sensorelementen **(13)** der Vielzahl von Sensormodulen **(100)** zusammenschaltbar ist.

9. Verfahren zum kapazitiven Erfassen der Annäherung eines Objekts und zum kapazitiven Erfassen von taktilen Ereignissen, umfassend die Schritte:
**a.** Bereitstellen eines oder mehrerer Sensormodule **(100)** nach einem der Ansprüche **1** bis **6** oder Bereitstellen eines Sensorsystems nach Anspruch **7** oder **8;**
**b.** Betreiben der Sensorelemente **(100)** in der selbst-kapazitiven Annäherungskonfiguration oder der beidseitig-kapazitiven Annäherungskonfiguration und Erfassen von Annäherung eines Objekts,
und/oder
**c.** Betreiben der Sensorelemente **(100)** in der beidseitig-kapazitiven Taktilitätskonfiguration und Erfassen von Taktilität,
**dadurch gekennzeichnet, dass**
**d.** die Sensorelemente **(100)** in der beidseitig-kapazitiven Prüf-Konfiguration betrieben werden.

10. Verfahren nach Anspruch **9,**
**a.** wobei die Sensorelemente **(100)** abwechselnd in der selbst-kapazitiven Annäherungskonfiguration, in der beidseitig-kapazitiven Annäherungskonfiguration betrieben werden.

11. Verwendung eines Sensormoduls **(100)** nach einem der Ansprüche **1** bis **6** oder eines Sensorsystems nach Anspruch **7** oder **8**
**a.** als taktiler Näherungssensor in funktionalen Oberflächen,
**b.** als taktiler Näherungssensor in einem Hubwagen
und/oder
**c.** zur Ausbildung einer Sensorhaut in der Robotik.

## Claims

1. Detection module **(100)** for capacitive detection of the approach of an object **(1)** to the detection module **(100)** and for capacitive detection of tactile events between an object **(1)** and the detection module **(100),** comprising:
a. at least three detection elements **(13, 8a, 8b),**
i. the sensor elements **(13, 8a, 8b)** being at least partially electrically conductive and arranged one above the other and at a distance from one another such that a stack of sensor elements is formed and an electrical potential is applicable to each of the sensor elements **(13, 8a, 8b)** and the sensor elements are electrically insulated from one another, and
ii. the stack of sensing elements comprising at least a first and a second outer sensing element **(13, 8b),** and at least one central sensing element **(8a)** arranged between the two outer sensing elements;
b. at least one compressible layer **(10)** placed between two of the sensing elements **(8a, 8b);**
whereby
c. the sensor module **(100)** is configured to be operable in three different measurement configurations and at least one bilateral capacitive control configuration,
i. measurement configurations comprising:
1. a self-capacitive approach configuration
2. a bilateral capacitive approach configuration,
and
3. a bilateral capacitive tactility configuration;
and
ii. the approach and bilateral capacitive tactile configurations being operable simultaneously.

2. Detection module **(100)** according to claim 1, comprising a measurement unit configured to operate the detection elements **(13, 8a, 8b)** in the measurement and control configurations.

3. Detection module **(100)** according to claim 2,
a. wherein the measuring module comprises two capacitance measuring devices **(40)** comprising:
i. a first capacitance measuring device, configured so that an approach measurement can be performed and a shielding potential generated, and
ii. a second capacitance measurement device, configured so that a tactile measurement and a control measurement can be performed.

4. Detection module **(100)** according to claim 2 or 3, wherein the measuring unit comprises an excitation signal generating unit **(20),** a first capacitance measuring device and a second capacitance measuring device **(40):**
a. in the self-capacitive approach configuration, at least one of the outer sensing elements **(13, 8b)** being connected both to the excitation signal generating unit and to the first capacitance measuring device, and wherein the central sensing element **(8a)** operates at shield potential;
b. in the bilateral capacitive approach configuration, at least one of the first external sensing elements **(13)** being connected to the first capacitance measuring device, and wherein the central sensing element **(8a)** operates at shield potential;
and
c. in the bilateral capacitive tactility configuration, at least one of the first external sensing elements **(13)** being connected to the excitation signal generating unit and the central sensing element **(8a)** operating at shield potential, and at least one of the second external sensing elements **(8b)** being connected to the second capacitance measuring device.

5. Detection module **(100)** according to one of the preceding claims 2 to 4,
a. wherein the measuring unit is configured such that, in the self-capacitive approach configuration, a capacitance or a change in capacitance between at least one of the external sensing elements **(13, 8b)** and an object **(1)** is measurable,
b. the measuring unit being configured such that, in the bilateral capacitive approach configuration, a capacitance or a change in capacitance between at least one of the outer sensing elements **(13, 8b)** of the sensing module **(100.1)** and one of the outer sensing elements **(13, 8b)** of the measuring module **(100.2)** is measurable,
and
c. wherein the measuring unit is configured such that, in the bilateral capacitive tactility configuration, a capacitance or a change in capacitance between at least one of the central sensor elements **(8a)** and one of the outer sensor elements **(13, 8b)** is measurable.

6. Detection module **(100)** according to one of the preceding claims 2 to 5,
a. the measurement module comprising an amplifier circuit **(32)** for detecting the approach in the auto-capacitive approach configuration and an amplifier circuit **(36)** for detecting the approach in the bilateral capacitive approach configuration,
and/or
b. the measuring unit comprising an amplifier circuit **(34)** for the tactility detection,
and/or
c. the measuring unit comprising an amplifier circuit **(41)** for the control measurement,
and/or
d. the measuring unit comprising a voltage follower **(31),**
i. the voltage follower **(31)** being electrically conductively coupled to the at least one central sensing element **(8a)** in the auto-capacitive approach configuration and/or in the bilateral capacitive approach configuration.

7. A sensor system for capacitive detection of the approach of an object to the sensor module **(100)** and for capacitive detection of tactile events between an object **(1)** and the sensor module **(100),** comprising a plurality of sensor modules **(100)** according to one of the preceding claims 1 to 6.

8. Detection system according to claim 7,
a. the sensor modules **(100)** being arranged in an array,
and/or
b. the measuring units of the sensor modules **(100)** being configured in such a way that respectively two adjacent clusters of first outer sensor elements **(13)** of the plurality of sensor modules **(100)** can be interconnected.

9. A method of capacitive detection of the approach of an object and capacitive detection of tactile events, comprising the steps:
a. providing one or more detection modules **(100)** according to one of the claims 1 to 6 or providing a detection system according to claim 7 or 8;
b. operating the detection elements **(100)** in the self-capacitive approach configuration or in the bilateral capacitive approach configuration and detecting the approach of an object,
and/or
c. operating the sensing elements **(100)** in the bilateral capacitive tactility configuration and detecting tactility,
**characterized in that**,
d. the sensing elements **(100)** operate in the bilateral capacitive control configuration.

10. A method according to claim 9,
a. wherein the sensing elements **(100)** operate alternately in the self-capacitive approach configuration, in the bilateral capacitive approach configuration.

11. Use of a detection module **(100)** according to one of claims 1 to 6 or of a detection system according to claim 7 or 8.
a. as a tactile proximity sensor in functional surfaces,
b. as a tactile proximity sensor in a lift truck
and/or
c. to form a sensor skin in robotics.

## Revendications

1. Module de détection **(100)** pour la détection capacitive de l'approche d'un objet **(1)** vers le module de détection **(100)** et pour la détection capacitive d'événements tactiles entre un objet **(1)** et le module de détection **(100),** comprenant :
a. au moins trois éléments de détection **(13, 8a, 8b),**
i. les éléments de détection (13, 8a, 8b) étant au moins partiellement conducteurs électriques et disposés les uns au-dessus des autres et à distance les uns des autres de telle sorte qu'il se forme un empilement d'éléments de détection et qu'un potentiel électrique est applicable à chacun des éléments de détection **(13, 8a, 8b)** et que les éléments de détection sont isolés électriquement les uns des autres, et
ii. l'empilement d'éléments de détection comprenant au moins un premier et un deuxième élément de détection extérieur **(13, 8b),** et au moins un élément de détection central **(8a)** disposé entre les deux éléments de détection extérieurs ;
b. au moins une couche compressible **(10)** placée entre deux des éléments de détection **(8a, 8b)** ;
c. le module de détection **(100)** étant configuré de telle sorte qu'il peut fonctionner avec trois configurations de mesure différentes et au moins une configuration de contrôle capacitive bilatérale,
i. les configurations de mesure comprenant :
1. une configuration d'approche autocapacitive
2. une configuration d'approche capacitive bilatérale, et
3. une configuration de tactilité capacitive bilatérale ; et
ii. les configurations capacitives et de tactilité capacitive bilatérale peuvent fonctionner simultanément.

2. Module de détection **(100)** selon la revendication 1, comprenant une unité de mesure configurée de manière à faire fonctionner les éléments de détection **(13, 8a, 8b)** dans les configurations de mesure et de contrôle.

3. Module de détection **(100)** selon la revendication 2,
a. dans lequel le module de mesure comprend deux dispositifs de mesure de capacité **(40)** comprenant :
i. un premier dispositif de mesure de capacité, configuré de telle sorte qu'une mesure d'approche peut être effectuée et qu'un potentiel de blindage peut être généré, et
ii. un deuxième dispositif de mesure de capacité, configuré de telle sorte qu'une mesure tactile et une mesure de contrôle peuvent être effectuées.

4. Module de détection **(100)** selon la revendication 2 ou 3, dans lequel l'unité de mesure comprend une unité de génération de signal d'excitation **(20),** un premier dispositif de mesure de capacité et un second dispositif de mesure de capacité **(40)** :
a. dans la configuration d'approche auto-capacitive, au moins l'un des éléments de détection extérieurs **(13, 8b)** étant connecté à la fois à l'unité de génération de signal d'excitation et au premier dispositif de mesure de capacité, et dans lequel l'élément de détection central **(8a)** fonctionne avec le potentiel de blindage ;
b. dans la configuration d'approche capacitive bilatérale, l'un au moins des premiers éléments de détection externes **(13)** étant connecté au premier dispositif de mesure de capacité, et dans laquelle l'élément de détection central **(8a)** fonctionne avec le potentiel de blindage ; et
c. dans la configuration de tactilité capacitive bilatérale, l'un au moins des premiers éléments de détection extérieurs **(13)** étant connecté à l'unité de génération de signal d'excitation et l'élément de détection central **(8a)** fonctionnant avec le potentiel de blindage, et l'un au moins des deuxièmes éléments de détection extérieurs **(8b)** étant connecté au deuxième dispositif de mesure de capacité.

5. Module de détection **(100)** selon l'une des revendications précédentes 2 à 4,
a. dans lequel l'unité de mesure est configurée de telle sorte que, dans la configuration d'approche auto-capacitive, une capacité ou un changement de capacité entre au moins l'un des éléments de détection extérieurs **(13, 8b)** et un objet **(1)** est mesurable,
b. l'unité de mesure étant configurée de telle sorte que, dans la configuration d'approche capacitive bilatérale, une capacité ou une modification de la capacité entre au moins l'un des éléments de détection extérieurs **(13, 8b)** du module de détection **(100.1)** et un des éléments de détection extérieur **(13, 8b)** du module de mesure **(100.2)** est mesurable,
et
c. dans lequel l'unité de mesure est configurée de telle sorte que, dans la configuration de tactilité capacitive bilatérale une capacité ou une modification de la capacité entre l'un au moins des éléments de détection centraux **(8a)** et l'un des éléments de capteur extérieurs **(13, 8b)** est mesurable.

6. Module de détection **(100)** selon l'une des revendications précédentes 2 à 5,
a. le module de mesure comprenant un circuit amplificateur **(32)** pour détecter l'approche dans la configuration d'approche auto-capacitive et un circuit amplificateur **(36)** pour détecter l'approche dans la configuration d'approche capacitive bilatérale,
et/ou
b. l'unité de mesure comprenant un circuit amplificateur **(34)** pour la détection de la tactilité,
et/ou
c. l'unité de mesure comportant un circuit amplificateur **(41)** pour la mesure de contrôle,
et/ou
d. l'unité de mesure comprenant un suiveur de tension **(31),**
i. le suiveur de tension **(31)** étant couplé de manière électriquement conductrice avec le au moins un élément de détection central **(8a)** dans la configuration d'approche auto-capacitive et/ou dans la configuration d'approche capacitive bilatérale.

7. Système de détection capacitive d'approche d'un objet vers le module de détection **(100)** et de détection capacitive d'événements tactiles entre un objet **(1)** et le module de détection **(100)** comprenant une pluralité de modules de détection **(100)** selon l'une des revendications précédents 1 à 6.

8. Système de détection selon la revendication 7,
a. les modules de détection **(100)** étant disposés en réseau,
et/ou
b. les unités de mesure des modules de détection **(100)** étant configurées de telle sorte que respectivement deux clusters contigus de premiers éléments de détection extérieurs **(13)** de la pluralité de modules de détection **(100)** peuvent être interconnectés.

9. Procédé de détection capacitive de l'approche d'un objet et de détection capacitive d'événements tactiles, comprenant les étapes :
a. fournir un ou plusieurs modules de détection **(100)** selon l'une quelconque des revendications 1 à 6 ou fournir un système de détection selon la revendication 7 ou 8 ;
b. faire fonctionner les éléments de détection **(100)** dans la configuration d'approche autocapacitive ou dans la configuration d'approche capacitive bilatérale et détecter l'approche d'un objet,
et/ou
c. faire fonctionner les éléments de détection **(100)** dans la configuration de tactilité capacitive bilatérale et détecter la tactilité,
**caractérisé en ce que**
d. les éléments de détection **(100)** fonctionnent dans la configuration de contrôle capacitive bilatérale.

10. Procédé selon la revendication 9,
a. dans lequel les éléments de détection **(100)** fonctionnent alternativement dans la configuration d'approche autocapacitive, dans la configuration d'approche capacitive bilatérale.

11. Utilisation d'un module de détection **(100)** selon l'une des revendications 1 à 6 ou d'un système de détection selon la revendication 7 ou 8
a. comme capteur de proximité tactile dans des surfaces fonctionnelles,
b. comme capteur de proximité tactile dans un chariot élévateur
et/ou
c. pour former une peau de capteur dans la robotique.
